# EUROPEAN PATENT SPECIFICATION

(11) **EP 2 047 009 B1**
(45) Date of publication and mention of the grant of the patent: **27.04.2016**
(21) Application number: 07796728.9
(22) Date of filing: 06.07.2007
(51) Int. Cl.: C23C 16/448, C23C 16/455, H01L 21/67, C23C 16/00

(54) **METHODS AND APPARATUS FOR THE VAPORIZATION AND DELIVERY OF SOLUTION PRECURSORS FOR ATOMIC LAYER DEPOSITION**
VERFAHREN UND VORRICHTUNG ZUR VERDAMPFUNG UND ZUFUHR VON LÖSUNGSVORLÄUFERN FÜR DIE ATOMLAGENABSCHEIDUNG
PROCÉDÉS ET APPAREIL POUR LA VAPORISATION ET L'ADMINISTRATION DE PRÉCURSEURS DE SOLUTION POUR UN DÉPÔT DE COUCHE ATOMIQUE

(30) Priority: 21.07.2006 US 832558 P
(43) Date of publication of application: 15.04.2009
(73) Proprietor: Linde LLC, Murray Hill, NJ 07974 (US)
(72) Inventor: WANG, Qing, Min, North Andover, MA 01845 (US); HELLY, Patrick, J., Valley Center, CA 92082 (US); MA, Ce, San Diego, CA 92130 (US)
(74) Representative: Boult Wade Tennant
(86) International application number: PCT/US2007/015596
(87) International publication number: WO 2008/013665

(56) References cited:
- EP-A1- 1 659 130
- US-A1- 2004 079 286
- US-A1- 2005 250 347
- US-A1- 2005 255 243
- US-A1- 2006 035 470
- US-A1- 2006 045 970
- US-A1- 2006 110 533
- US-A1- 2006 144 333

## Description

### Field of the Invention

The present invention relates to new and useful methods and apparatus for producing thin films using atomic layer deposition (ALD) processes. Methods and apparatus for the vaporization and delivery of solution ALD precursors to produce high quality thin films from a wide selection of precursors are described.

### Background of the Invention

Atomic layer deposition (ALD) is an enabling technology for next generation conductor barrier layers, high-k gate dielectric layers, high-k capacitance layers, capping layers, and metallic gate electrodes in silicon wafer processes. ALD has also been applied in other electronics industries, such as flat panel display, compound semiconductor, magnetic and optical storage, solar cell, nanotechnology and nano materials. ALD is used to build ultra thin and highly conformal layers of metal, oxide, nitride, and others one monolayer at a time in a cyclic deposition process. Oxides and nitrides of many main group metal elements and transition metal elements, such as aluminum, titanium, zirconium, hafnium, and tantalum, have been produced by ALD processes using oxidation or nitridation reactions. Pure metallic layers, such as Ru, Cu, Ta, and others may also be deposited using ALD processes through reduction or combustion reactions.

A typical ALD process is based on sequential applications of at least two precursors to the substrate surface with each pulse of precursor separated by a purge. Each application of a precursor is intended to result in a single monolayer of material being deposited on the surface. These monolayers are formed because of the self-terminating surface reactions between the precursors and surface. In other words, reaction between the precursor and the surface proceeds until no further surface sites are available for reaction. Excess precursor is then purged from the deposition chamber and the second precursor is introduced. Each precursor pulse and purge sequence comprises one ALD half-cycle that results in a single additional monolayer of material. Because of the self-terminating nature of the process, even if more precursor molecules arrive at the surface, no further reactions will occur. It is this self-terminating characteristic that provides for high uniformity, conformality and precise thickness control when using ALD processes.

The present invention relies on solvent based precursors. Examples of suitable solvent based precursors are disclosed in applicants co-pending US patent application serial number 11/400,904, filed April 10, 2006 published as US2006269667 A1. Examples of the precursor solute that can be selected from a wide range of low vapor pressure solutes or solids as set forth in Table 1.

**Table 1. Examples of ALD precursor solutes**

| **Name** | **Formula** | **MW** | **Mp (°C)** | **bp (°C / mmHg)** | **Density (g/mL)** |
|---|---|---|---|---|---|
| Tetrakis(ethylmethylamino )hafnium (TEMAH) | Hf[N(EtMe)]₄ | 410.9 | -50 | 79/0.1 | 1.324 |
| Hafnuim (IV) Nitrate, anhydrous | Hf(NO₃)₄ | 426.51 | > 300 | n/a | |
| Hafnuím (IV) Iodide, anhydrous | HfL₄ | 686.11 | 400 (subL) | n/a | 5.6 |
| Dimethylbis(*t*-butyl cyclopentadienyl hafnium(lV) | [(*t*-Bu)Cp]₂HfMe₂ | 450.96 | 73-76 | n/a | |
| Tetrakis(1-methoxy-2-methyl-2-propoxide) hafnium (IV) | Hf(O₂C₅H₁₁)₄ | 591 | n/a | 135/0.01 | |
| Di(cyclopentadienyl)Hf dichloride | Cp₂HfCl₂ | 379.58 | 230-233 | n/a | |
| Hafnium tert-butoxide | Hf(OC₄H₉)₄ | 470.94 | n/a | 90/5 | |
| Hafnium ethoxide | Hf(OC₂H₅)₄ | 358.73 | 178-180 | 180-200 / 13 | |
| Aluminum i-propoxide | Al(OC₃H₇)₃ | 204.25 | 118.5 | 140.5/8 | 1.0346 |
| Lead *t*-butoxide | Pb(OC(CH₃)₃)₂ | 353.43 | | | |
| Zirconium (IV) *t*-butoxide | Zr(OC(CH₃)₃)₄ | 383.68 | | 90/5; 81/3 | 0.985 |
| Titanium (IV) *i*-propoxide | Ti(OCH(CH₃)₂)₄ | 284.25 | 20 | 58/1 | 0.955 |
| Barium i-propoxide | Ba(OC₃H₇)₂ | 255.52 | 200ec ) | n/a | |
| Strontium i-propoxide | Sr(OC₃H₇)₂ | 205.8 | | | |
| Bis(pentamethylCp) Barium | Ba(C₅Me₅)₂ | 409.8 | | | |
| Bis(tripropylCp) Strontium | Sr(C₅*i*-Pr₃H₂)₂ | 472.3 | | | |
| (Trimethyl)pentamethylcyc lopentadienyl titanium (IV) | Ti(C₅Me₅)(Me₃) | 228.22 | | | |
| Bis(2,2,6,6-tetramethyl-3,5-heptanedionato) barium triglyme adduct | Ba(thd)₂ * triglyme | 503.85 (682.08) | 88 | | |
| Bis(2,2,6,6-tetramethyl-3,5-heptanedionato) strontium triglyme adduct | Sr(thd)₂ * triglyme | 454.16 (632.39) | 75 | | |
| Tris(2,2,6,6-tetramethyl-3,5-heptanedionato) titanium(III) | Ti(thd)₃ | 597.7 | | 75/0.1 (sp) | |
| Bis(cyclpentadinyl)Rutheni um (II) | RuCp₂ | 231.26 | 200 | 80-85/0.01 | |

Other examples of precursor solutes include Ta(NMe₂)₅ and Ta(NMe₂)₃(NC₉H₁₁) that can be used as Tantalum film precursors.

The selection of solvents is critical to the ALD precursor solutions. In particular, examples of solvents useful with the solutes noted above are given in Table 2.

**Table 2. Examples of solvents**

| **Name** | **Formula** | **BP@760Torr (°C)** |
|---|---|---|
| Dioxane | C₄H₈O₂ | 101 |
| Toluene | C₇H₈ | 110.6 |
| n-butyl acetate | CH₃CO₂(n-Bu) | 124-126 |
| Octane | c₈H₁₈ | 125-127 |
| Ethylcyclohexane | C₈H₁₆ | 132 |
| 2-Methoxyethyl acetate | CH₃CO₂(CH₂)₂OC H₃ | 145 |
| Cyclohexanone | C₆H₁₀O | 155 |
| Propylcyclohexane | C₉H₁₈ | 156 |
| 2-Methoxyethyl Ether (diglyme) | (CH₃OCH₂CH₂)₂O | 162 |
| Butylcyclohexane | C₁₀H₂₀ | 178 |

Another example of a solvent useful for the present invention is 2,5-dimethyloxytetrahydrofuran.

By using solvent based precursors for ALD, it is possible to use less volatile precursors in any physical form. Further, because dilute precursors are used, chemical utilization efficiency is improved. The copending application noted above also discloses two vaporization/delivery modes; i.e. constant pumping speed and constant pressure mode in the vaporizer. In constant pumping speed mode, room temperature gas swing systems are used to pulse hot vapor to the deposition chamber and during pulse off time, the vapor is diverted downstream of the deposition chamber. In constant pressure mode, high temperature pressure gauges and valves are required.

Therefore, there remains a need in the art to further improve chemical utilization efficiency of solvent based precursors.

EP-A-1 659 130 relates to a method of chemical vapor deposition employing specified chemical compounds. The method may be performed as an ALD method. A solution of the required chemical compound is formed in line by mixing separate flows of solvent and active compound. The solution is vaporised upstream of deposition. US -A-2006/0045970 relates to an ALD process in which a volatile substance is vaporised by bubbling and deposited.

### Summary of Invention

According to the present invention there is provided a deposition apparatus as defined in claim 1 below. The invention also provides a method of depositing a thin film as defined in claim 6 below.

The present invention provides improved methods and apparatus for the vaporization and delivery of solution ALD precursors. The present invention is particularly useful for processing lower volatile metal, metal oxide, metal nitride and other thin film precursors. The present invention uses total vaporization chambers and room temperature valve systems to generate true ALD vapor pulses. Utilization efficiency of the solution precursors is enhanced according to the present invention by combining liquid dosing with vapor phase pulse schemes. The result is high quality ALD thin films that can be deposited from a wide selection of precursors.

### Brief Description of Drawings

Figure 1 is a schematic drawing of an apparatus according to one embodiment of the present invention.
Figure 2 is a schematic drawing of an apparatus according to another embodiment of the present invention.
Figure 3 is a schematic drawing of an apparatus according to a further embodiment of the present invention.

### Detailed Description of the Invention

The present invention is directed to methods and apparatus that utilize a combination of liquid and vapor phases that are modulated or pulsed to delivery precise ALD doses of the solution precursors. The present invention provides a number of advantages over methods and apparatus known in the prior art.

In particular, precursor consumption can be reduced by up to 90% over the previously mentioned copending application (e.g. 1 sec liquid pulse over 10 sec ALD cycle time). Further, a smaller form factor for the solution source container (e.g. standard 1 liter dip tube electro-polished stainless steel containers) is possible which in turn allow for a smaller form factor vaporizer and a smaller overall tool footprint. In addition, room temperature valve systems can still be used, but diversion of the solution liquid precursor during ALD vapor pulse off period is not longer necessary as will be explained in greater detail below.

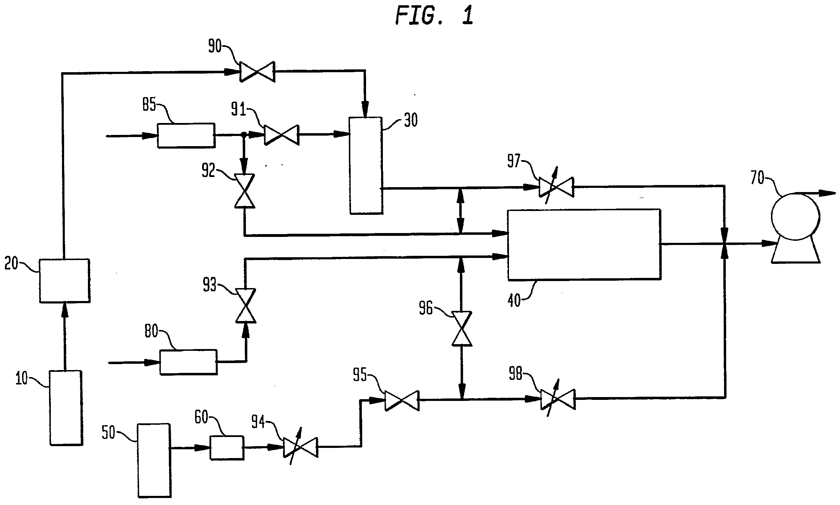

Figures 1, 2 and 3 are all schematic views of apparatus according to the present invention. In each case, the apparatus comprises a number of parts: i.e. a solution source; liquid metering or flow movement means; liquid modulation means; a vaporizer; a valve system; and an ALD deposition chamber. Throughout the drawings, like reference numbers are used for like parts.

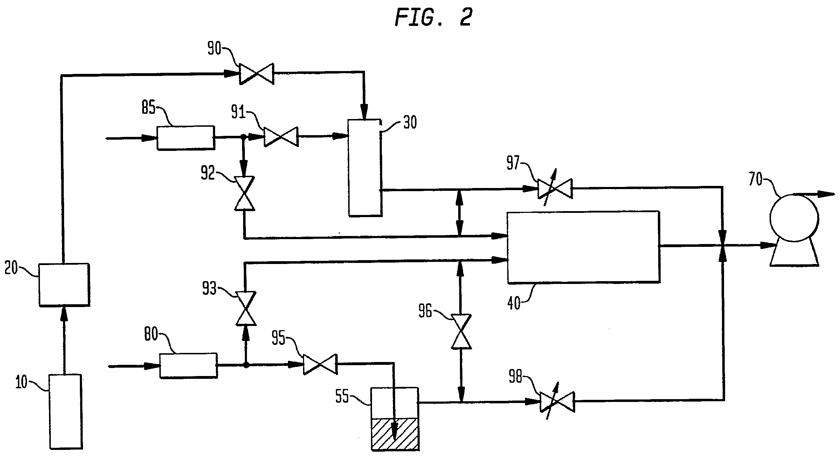

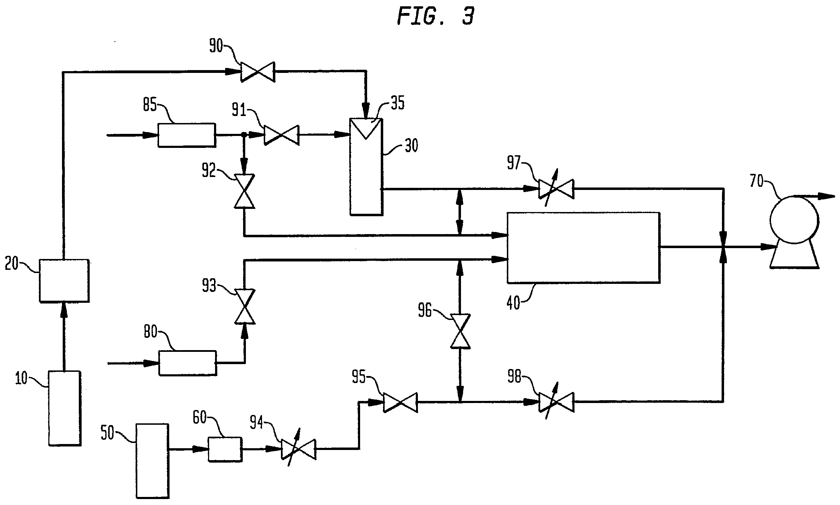

In particular, in Figures 1, 2 and 3, the apparatus comprises a solution source vessel 10 in fluid connection with a vaporizer 30 via a pump 20 and valve 90. The vaporizer 30 may include a checker valve or injector nozzle 35 (Figure 3). Also connected to the vaporizer 30 is a purge gas source (not shown) through a mass flow controller 85 and valve 91. The vaporizer is further connected to a deposition chamber 40, or to system pump 70 through valve 97. The mass flow controller 85 can also provide purge gas to the deposition chamber 40 through valve 92. A separate purge gas source (not shown) can also provide purge gas to the deposition chamber 40 through a mass flow controller 80 and valve 93. As shown in Figures 1 and 3 a gas source vessel 50 provides the gas to the deposition chamber 40 through a regulator 60 and a series of valves 94, 95 and 96. Alternatively, gas can be sent to the system pump 70 through valve 98. The deposition chamber 40 is also connected to the system pump 70. In a separate embodiment as shown in Figure 2, a liquid reactant vessel 55 provides liquid reactant to the deposition chamber 70 through valve 96 or to the system pump 70 through valve 98. In this embodiment, the purge gas is sent through the mass flow controller 80 and valve 95 into the liquid reactant vessel 55.

The solution source may be stored in the solution source vessel 10 at room temperature. This solution source comprises an ALD precursor dissolved in one or more solvents. The precursor can be a solid, a liquid, or a gas. A large number of precursors can be used, including those with low volatility, and a wide range of boiling and melting temperatures. The precursors can be metal organics or inorganics and can be suitable for building part of a metal, oxide, nitride, or other type of thin film using an ALD process. The solvent should have a dissolving power for the chosen precursor of greater than 1 molar, greater than 0.01 molar or greater than 0.1 molar. In addition, the solvent should have physical and chemical properties similar to those of the precursor and be selected to have compatible vaporization properties with the precursor to assure full vaporization without generating residue. The solution source vessel 10 preferable has a dip tube for liquid delivery, a pressurization gas port and a solution recharge port.

As shown in Figures 1, 2 and 3, solution is moved out of solution source vessel 10 using a pump 20. This pump 20 may take several different forms. Preferably, the pump 20 takes the form of a calibrated capillary line and solution is moved into the capillary line by pressure applied through the gas port of the solution source vessel using an inert gas. The inert gas preferably is provided in the range of 0 to 50 psig. Alternatively, the pump 20 may be a liquid mass flow controller, a liquid pump or a syringe pump. In accordance with the present invention the solution is moved at room temperature without vaporization, decomposition, or separation.

The amount of solution provided to the vaporizer 30 is modulated or controlled by valve 90 which is an on/off switching valve. The dose of solution provided to the vaporizer 30 is selected according to the amount needed for the ALD vapor pulse and is controlled to avoid excessive solution precursor loss during the ALD vapor pulse off period. The valve 90 can be an ALD two port valve or alternatively can have a predetermined liquid storage volume; e.g. HPLC type multi-port valve with capillary storage tubes. As shown in Figure 3, the solution dose can be further separated and controlled by a checker valve or injection nozzle 35 to ensure the solution dose remains liquid phase before entering the vaporizer 30. The valve 90 is thermally isolated by the use of thermal insulator conduit; e.g. ceramic feed through pipes.

The vaporizer 30 includes a solution dose inlet, a hot inert gas inlet and a hot vapor outlet. The vaporizer preferably includes an internal and an external energy source to ensure full vaporization of the solution precursor dose without causing separation and decomposition. In operation, the solution dose enters the vaporizer 30 and is flashed into vapor phase under reduced pressure and hot vaporization chamber. The partial pressure of the precursor should be maintained under the saturation pressure for the precursor compound at the vaporizer 30 operation temperature. Following a controlled time delay, a controlled amount of inert gas is provided from inert gas source using mass flow controller 85 and valve 91. This inert gas carries the vaporized precursor out of the vaporizer 30 through the hot vapor outlet. The present invention assures that the hot vapor is in uniform gas phase at the desired concentration. The inert gas is preferably is preheated, such as by heat exchange with the external energy source for the vaporizer 30. The inert gas is preferably injected around the solution dose inlet to create a stream of jets. The internal and external energy sources for the vaporizer 30 can be electrically heated surfaces. As shown in Figures 1, 2 and 3 the solution dose inlet and hot inert gas inlet are located near the top of the vaporizer 30, while the hot vapor outlet is near but above the bottom of the vaporizer 30. To provide further purification to the vapor, an inert filter medium can be used in the hot vapor outlet.

The valve system for the apparatus according to the present invention utilizes a number of different valve types. In particular, valves 90, 91 and 95 are ALD valves, valves 92, 93, 94, 97 and 98 are metering valves and valve 96 is an on/off valve. One advantage of the present invention is that all of the valves used are room temperature liquid or gas valves. This allows the gas valves to be switched on and off with fast response time. It should be noted that while Figures 1, 2 and 3 all show two separate mass flow controllers for the inert gas, it would be possible to combine these into a single unit with appropriate valves and control. The other reactant provided from either gas source vessel 50 or from liquid reactant vessel 55 can be in gaseous or liquid form; e.g. oxygen, air, ammonia, ozone, water, hydrogen, plasma forms of the preceding, etc.

The ALD deposition chamber 40 can be constructed for a single wafer or a batch of wafers. Typical operating conditions for the deposition chamber 40 are pressure from 0.1 to 50 Torr and independent substrate heaters from 50°C to 800°C. It is preferable that the conduits extending between the vaporizer 30 and deposition chamber 40 include heating means so the hot vapor can be maintained at or above the temperature of the vaporizer 30. The hot vapor can be delivered into the deposition chamber by simple flowing inlet or shower head. It is also preferable to operate the deposition chamber 40 at a lower pressure and than the vaporizer 30 and at a temperature lower than the vaporization temperature. In accordance with the present invention, the hot vapor precursor is directed to the substrate with minimum loss to the deposition chamber 30 walls.

The operation of the apparatus according to the present invention can be described as follows.
With ALD valves 90, 91 and 95 switched off, the system is purged using inert gas flowing through valves 92, 93. This purge can continue for 0.1 to 50 seconds.
ALD valve 95 is opened to deliver reactant either from gas source vessel 50 (Figures 1 and 3) or liquid reactant vessel 55 (figure 2) to the deposition chamber. This delivery can continue for 0.1 to 50 seconds.
ALD valve 95 is closed, (ALD valves 90 and 91 remain closed) and the system is again purged with inert gas for 0.1 to 50 seconds.
ALD (or liquid valve) 90 is opened to deliver a solution precursor dose to the vaporizer 30. This delivery can extend for 0.1 to 50 seconds.
ALD valve 90 is closed, (valves 91 and 95 remain closed) and the system is purged with inert gas for 0.1 to 50 seconds.
ALD valve 91 is opened to deliver hot inert gas to the vaporizer 30 and thereby create the hot vapor precursor dose which is delivered to the deposition chamber 40. This delivery can also run from 0.1 to 50 seconds.
The above steps are repeated to build up successive ALD layers.

In accordance with the present invention, the time delay between the solution pulse and the hot vapor pulse; i.e. the third purge stage, is adjusted to minimize precursor vapor loss through the system pump 70. More particularly, in operation, inert gas via either mass flow controller 80 and valve 93, or mass flow controller 85 and valve 92 continues to flow through the system even when the ALD valves 90, 91 or 95 are open. When the ALD valves 90, 91 and 95 are closed, this inert gas creates a diffusion barrier that blocks the precursor vapor coming from the vaporizer 30 and diverts any excess precursor vapor to the system pump 70. However when an ALD valve is open, for example, when ALD valve 91 is opened, the hot precursor vapor created is carried out of the vaporizer 30 at a pressure sufficient to overcome the diffusion barrier pressure and allow the precursor vapor to enter the deposition chamber 40. The pressure of the diffusion barrier is determined by the vacuum setting of the deposition chamber 40.

While the above describes an ALD process using to precursor sources, additional sources can be installed. For example, to produce mixed component ALD films, e.g. HfAlOx, a separate solution precursor source for both Hafnium and Aluminum can be included in the system along with the reactant source. Although mixing two or more precursors together in one solution source is possible, providing separate solution sources gives greater flexibility in composition control.

It is anticipated that other embodiments and variations of the present invention will become readily apparent to the skilled artisan in the light of the foregoing description, and it is intended that such embodiments and variations likewise be included within the scope of the invention as set out in the appended claims.

## Claims

1. An atomic layer deposition apparatus comprising:
a precursor solution source vessel (10);
a reactant source (50);
a first purge gas source;
a second purge gas source;
a vaporizer (30) in fluid connection with both the precursor solution source vessel (10) and the first purge gas source;
a deposition chamber (40) in fluid connection with each of the reactant source (50), the first purge gas source, the second gas purge gas source and the vaporizer (30);
and a system pump (70) in fluid connection with each of the reactant source (50), the vaporizer (30) and the deposition chamber (40),
wherein the atomic layer deposition apparatus comprises an on/off switching valve (90) to modulate or control the amount of solution provided to the vaporizer (30) to provide doses of solution in the amount needed for an atomic layer deposition vapour pulse,
**characterized in that**
the valve (90) is thermally isolated from the vaporizer (30) by the use of a thermal insulator conduit.

2. The apparatus of claim 1 further comprising a pump (20) fluidly connected between the precursor solution source vessel (10) and the vaporizer (30), a regulator (60) associated with the reactant source (50), a first mass flow controller (85) associated with the first purge gas source, and a second mass flow controller (80) associated with the second purge gas source.

3. The apparatus of claim 1 further comprising a checker valve or an injector nozzle (35) in the vaporizer (30).

4. The apparatus of claim 1 wherein the reactant source (50) is a gas vessel.

5. The apparatus of claim 1 wherein the reactant source (50) is a liquid vessel.

6. A method of depositing a thin film comprising:
providing the apparatus of claim 1;
purging the deposition chamber (40) by allowing purge gas to flow from the first purge gas source and the second purge gas source through the deposition chamber (40);
delivering reactant from the reactant source (50) to the deposition chamber (40); purging the deposition chamber (40) by allowing purge gas to flow from the first purge gas source and the second purge gas source through the deposition chamber (40);
delivering precursor solution from the precursor solution source vessel (10) to the vaporizer (30);
vaporizing the precursor solution;
delivering the vaporized precursor solution to the deposition chamber (40);
purging the deposition chamber (40) by allowing purge gas to flow from the first purge gas source and the second purge gas source through the deposition chamber (40); and
repeating the above until a thin film having a desired thickness is achieved.

## Patentansprüche

1. Vorrichtung zur Atomlagenabscheidung, umfassend:
ein Quellgefäß (10) für Vorläuferlösung;
eine Reaktantquelle (50);
eine erste Spülgasquelle;
eine zweite Spülgasquelle;
einen Verdampfer (30) in Fluidverbindung mit sowohl dem Quellgefäß (10) für die Vorläuferlösung als auch der ersten Spülgasquelle;
eine Abscheidungskammer (40) in Fluidverbindung mit jedem von der Reaktantquelle (50), der ersten Spülgasquelle, der zweiten Spülgasquelle und dem Verdampfer (30);
und eine Systempumpe (70) in Fluidverbindung mit jedem von der Reaktantquelle (50), dem Verdampfer (30) und der Abscheidungskammer (40),
wobei die Vorrichtung zur Atomlagenabscheidung ein ein/aus-Schaltventil (90) zum Modulieren oder Steuern der Menge an Lösung umfasst, die dem Verdampfer (30) bereitgestellt wird, um Dosen der Lösung in der für einen Dampfpuls einer Atomlagenabscheidung benötigten Menge bereitzustellen,
**dadurch gekennzeichnet, dass**
das Ventil (90) von dem Verdampfer (30) durch Verwendung einer Wärmeisolatorrohrleitung thermisch isoliert ist.

2. Vorrichtung nach Anspruch 1, ferner umfassend eine Pumpe (20), die in Fluidverbindung zwischen dem Quellgefäß (10) für die Vorläuferlösung und dem Verdampfer (30) angeschlossen ist, einen Regulator (60), der mit der Reaktantquelle (50) zusammenhängt, einen ersten Massenflussregler (85), der mit der ersten Spülgasquelle zusammenhängt, und einen zweiten Massenflussregler (80), der mit der zweiten Spülgasquelle zusammenhängt.

3. Vorrichtung nach Anspruch 1, ferner umfassend ein Umsteuerventil oder eine Einspritzdüse (35) in dem Verdampfer (30).

4. Vorrichtung nach Anspruch 1, wobei die Reaktantquelle (50) ein Gasgefäß ist.

5. Vorrichtung nach Anspruch 1, wobei die Reaktantquelle (50) ein Flüssigkeitsgefäß ist.

6. Verfahren zum Abscheiden eines Dünnfilms, umfassend:
Bereitstellen der Vorrichtung nach Anspruch 1;
Spülen der Abscheidungskammer (40), indem Spülgas von der ersten Spülgasquelle und der zweiten Spülgasquelle durch die Abscheidungskammer (40) hindurch fließen gelassen wird;
Abgeben von Reaktant aus der Reaktantquelle (50) zu der Abscheidungskammer (40);
Spülen der Abscheidungskammer (40), indem Spülgas von der ersten Spülgasquelle und der zweiten Spülgasquelle durch die Abscheidungskammer (40) hindurch fließen gelassen wird;
Abgeben von Vorläuferlösung aus dem Quellgefäß (10) für Vorläuferlösung an den Verdampfer (30);
Verdampfen der Vorläuferlösung;
Abgeben der verdampften Vorläuferlösung an die Abscheidungskammer (40);
Spülen der Abscheidungskammer (40), indem Spülgas von der ersten Spülgasquelle und der zweiten Spülgasquelle durch die Abscheidungskammer (40) hindurch fließen gelassen wird; und
Wiederholen des Obigen, bis ein Dünnfilm mit der gewünschten Dicke erreicht ist.

## Revendications

1. Appareil de dépôt de couches atomiques comprenant :
une cuve de source de solution de précurseur (10) ;
une source de réactif (50) ;
une première source de gaz de purge ;
une deuxième source de gaz de purge ;
un vaporiseur (30) en connexion fluidique avec à la fois la cuve de source de solution de précurseur (10) et la première source de gaz de purge ;
une chambre de dépôt (40) en connexion fluidique avec à la fois la source de réactif (50), la première source de gaz de purge, la deuxième source de gaz de purge et le vaporiseur (30) ;
et une pompe de système (70) en connexion fluidique avec à la fois la source de réactif (50), le vaporiseur (30) et la chambre de dépôt (40),
l'appareil de dépôt de couches atomiques comprenant une vanne de commutation marche/arrêt (90) servant à moduler ou contrôler la quantité de solution fournie au vaporiseur (30) pour fournir des doses de solution dans la quantité nécessaire pour une impulsion de vapeur de dépôt de couches atomiques,
**caractérisé en ce que**
la vanne (90) est thermiquement isolée du vaporiseur (30) à l'aide d'un conduit d'isolant thermique.

2. Appareil de la revendication 1 comprenant en outre une pompe (20) raccordée fluidiquement entre la cuve de source de solution de précurseur (10) et le vaporiseur (30), un régulateur (60) associé à la source de réactif (50), un premier régulateur de débit massique (85) associé à la première source de gaz de purge, et un deuxième régulateur de débit massique (80) associé à la deuxième source de gaz de purge.

3. Appareil de la revendication 1 comprenant en outre un clapet anti-retour ou une buse d'injection (35) dans le vaporiseur (30).

4. Appareil de la revendication 1 dans lequel la source de réactif (50) est une cuve de gaz.

5. Appareil de la revendication 1 dans lequel la source de réactif (50) est une cuve de liquide.

6. Procédé de dépôt d'un film mince comprenant les étapes suivantes :
se procurer l'appareil de la revendication 1 ;
purger la chambre de dépôt (40) en laissant du gaz de purge circuler depuis la première source de gaz de purge et la deuxième source de gaz de purge à travers la chambre de dépôt (40) ;
délivrer le réactif depuis la source de réactif (50) à la chambre de dépôt (40) ;
purger la chambre de dépôt (40) en laissant du gaz de purge circuler depuis la première source de gaz de purge et la deuxième source de gaz de purge à travers la chambre de dépôt (40) ;
délivrer la solution de précurseur depuis la cuve de source de solution de précurseur (10) au vaporiseur (30) ;
vaporiser la solution de précurseur ;
délivrer la solution de précurseur vaporisée à la chambre de dépôt (40) ;
purger la chambre de dépôt (40) en laissant du gaz de purge circuler depuis la première source de gaz de purge et la deuxième source de gaz de purge à travers la chambre de dépôt (40) ; et
répéter les étapes précédentes jusqu'à ce qu'un film mince ayant une épaisseur souhaitée soit obtenu.
